(19) Europäisches Patentamt
European Patent Office
Office européen des brevets

(11) EP 0 488 273 B1

(12) **EUROPEAN PATENT SPECIFICATION**

(45) Date of publication and mention of the grant of the patent:
**02.05.1997 Bulletin 1997/18**

(21) Application number: **91120372.7**

(22) Date of filing: **28.11.1991**

(51) Int Cl.[6]: **C10M 169/00**, C10M 131/08, C10M 133/16, C10M 139/04, C10M 147/04, H01L 23/373 // C10N30/08

(54) **Electrical device containing a lubricant or heat conducting composition.**

Elektrisches Gerät enthaltend ein Schmiermittel oder eine wärmeleitende Zusammensetzung.

Appareil electrique contenant un composé lubrifiant ou conducteur de la chaleur.

(84) Designated Contracting States:
**DE FR GB**

(30) Priority: **28.11.1990 JP 323157/90**

(43) Date of publication of application:
**03.06.1992 Bulletin 1992/23**

(73) Proprietor: **HITACHI, LTD.**
**Chiyoda-ku, Tokyo 101 (JP)**

(72) Inventors:
- **Uematsu, Takao**
  **Hitachi-shi (JP)**
- **Shoji, Mitsuyoshi**
  **Ibaraki-ken (JP)**
- **Nakakawaji, Takayuki**
  **Hitachi-shi (JP)**
- **Komatsuzaki, Shigeki**
  **Mito-shi (JP)**
- **Ito, Yutaka**
  **Takahagi-shi (JP)**
- **Morihara, Atsushi**
  **Katsuta-shi (JP)**
- **Sato, Koji**
  **Hitachi-shi (JP)**
- **Zushi, Shizuo**
  **Hadano-shi (JP)**
- **Go, Hiroshi**
  **Zama-shi (JP)**

(74) Representative: **Beetz & Partner Patentanwälte**
**Steinsdorfstrasse 10**
**80538 München (DE)**

(56) References cited:
**US-A- 3 882 033** **US-A- 4 518 513**

- **PATENT ABSTRACTS OF JAPAN vol. 12, no. 279 (C-517)(3126) 1 August 1988**
- **PATENT ABSTRACTS OF JAPAN vol. 13, no. 61 (C-567)(3409) 10 February 1989**
- **PATENT ABSTRACTS OF JAPAN vol. 14, no. 377 (C-748)(4320) 15 August 1990**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 0 488 273 B1

Printed by Jouve, 75001 PARIS (FR)

## Description

This invention relates to electrical and electronical appliances as defined in the preambles of the independent claims 1 and 2.

Grease used for electronical or electrical appliances and precision instruments such as various kinds of sliding parts, various kinds of bearings, switches, electric contacts and the like are required in recent years to have more excellent characteristics regarding thermal stability at high temperatures and low friction torque at low temperatures in many cases. As base oils of such lubricants, generally used are low viscosity synthetic oils having good heat resistance in order to obtain such characteristics. However, the use of low viscosity synthetic oils causes problems of grease leakage or the separation of the base oil from the grease. There is a method of hardening the grease by adding a somewhat larger amount of a thickener having excellent shear stability for overcoming the problem of grease leakage.

Japanese Patent Application Kokai (Laid-Open) No. 57693/88 discloses non-diffusing greases containing fluorine based surfactants having fully fluorinated fluoro carbon chains (perfluoro carbon chains) as means for reducing base oil separation (bleeding) or oil diffusion. Since the surfactants disclosed therein are soluble in the base oil, the non-diffusing property of the oil is not so good in practice.

On the one hand, greases blended with heat conducting fillers to quickly radiate or transmit heat generated in electrical parts with ensuring electrical insulating properties in electrical appliances are disclosed in Japanese Patent Application Kokoku (Examined) No. 36302/82 and Japanese Patent Application Kokai (Laid-Open) No. 251455/88. However, in Japanese Patent Application Kokoku (Examined) No. 36302/82 no materials preventing oil diffusion or bleeding are added, and also in Japanese Patent Application Kokai (Laid-Open) No. 251455/88, base oil separation or bleeding occur owing to the use of surfactants having compatibility with the base oil, which may cause staining of the apparatus or defects in electrical contacts.

There are also disclosed "lubricating grease" in US 4 251 431, "grease composition" in US 4 132 660 and "perfluorated aliphatic polyalkyl ether lubricant containing additives of aromatic phosphine substituted with perfluoro alkyl ether group in US 4 438 007, and the like. Also in these compositions surfactants compatible with the base oil are used.

Greases or thermal compounds tend to bleed and diffuse the base oil from the coated parts with time after coating. The lower the viscosity of the base oil and the greater the penetration (softer) of the grease and further the higher the temperature in use, the more become such tendencies remarkable. Separated or bleeded base oil leads to staining of the apparatus or poor performances of electrical contacts, or promotes lowering or deterioration of mechanical properties of resins. Therefore, the development of a grease with little base oil separation or bleeding is recently strongly demanded in several fields. Especially, heat conducting compounds used in electronical or electrical appliances such as cooling structures and the like of computers are required to cause no base oil separation or bleeding because they are applied near semiconductor chips generating heat.

However, conventional compounds are not satisfactory in view of prevention of separation, bleeding or diffusion of the base oil.

It is an object of this invention to provide electrical and electronical applicances as defined in the preambles of claims 1 and 2 wherein separation, bleeding or diffusion of the base oil during the use of semi-solid compositions containing the base oil and a thickener are prevented.

The above underlying problem is solved according to the characterizing clauses of claims 1 and 2.

The electrical and electronical appliances of the present invention comprising sliding parts and a lubricant provided therebetween,
the lubricant being a composition comprising

- a non-fluorinated base oil selected from mineral oils, synthetic oils, and polydimethylsiloxanes,
- a powdery heat conducting inorganic filler selected from metal oxides, silicon carbide, silicon nitride, boron nitride and aluminium nitride, and
- a fluorinated organic compound comprising one or more perfluoropolyoxyalkyl groups or perfluoropolyoxyalkylene groups and a non-fluorinated group,

are characterized in that
the lubricant is a composition wherein the fluorinated organic compound has the general formula

$$(R_f)_n - X ,$$

wherein

$R_f$ is perfluoropolyoxyalkyl or perfluoropolyoxyalkylene,

X is a non-fluorinated organic group, and
n is 1 or 2.

The electrical and electronical appliances of the present invention, comprising

- a heat source,
- a heat sink for conducting heat from the heat source to the outside, and
- a heat conducting material being a composition comprising
  - a non-fluorinated base oil selected from mineral oils, synthetic oils, and polydimethylsiloxanes,
  - a powdery heat conducting inorganic filler selected from metal oxides, silicon carbide, silicon nitride, boron nitride and aluminium nitride, and
  - a fluorinated organic compound comprising one or more perfluoropolyoxyalkyl groups or perfluoropolyoxyalkylene groups and a non-fluorinated group,

are characterized in that
the heat conducting composition is a composition wherein the fluorinated organic compound has the general formula

$$(R_f)_n - X,$$

wherein

$R_f$ is perfluoropolyoxyalkyl or perfluoropolyoxyalkylene,
X is a non-fluorinated organic group,
and
n is 1 or 2 .

Primarily, the surfactant decreases the surface tension or interfacial tension of a liquid component such as a base oil or a heat conducting filler, and further promotes separation, bleeding or diffusion of the base oil. The present invention is based on the finding that separation, bleeding or diffusion of the base oil can be prevented by blending a specific fluorinated organic compound slightly soluble in the base oil in a composition containing the base oil and a thickener.

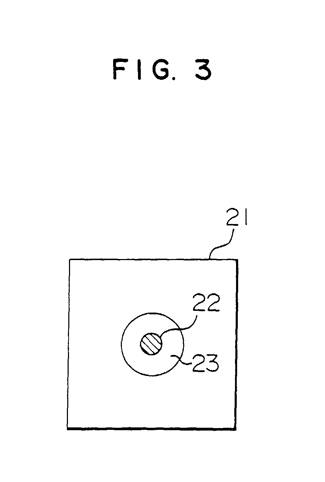

Figures 1 and 2 are perspective views of simulated cooling structures used to evaluate bleeding or diffusion of the base oil of the heat conducting material. Figure 3 is an illustrative view explaining the base oil diffusion evaluation test method.

The fluorinated organic compound used in the present invention is especially effective when used in combination with a non-fluorinated based synthetic base oil. Furthermore, the fluorinated organic compound is preferably a fluorinated surfactant slightly soluble in the synthetic oil (which results in colloid formation or floating up when mixed with the synthetic oil). The fluorine containing group is preferably obtained by combining a perfluoropolyoxyalkyl group or a perfluoropolyoxyalkylene group with a non-fluorinated organic group.

In the compositions of the present invention, one or more compounds represented by the formulae (i)-(iii) shown below are used especially effectively:

$$R_f\text{-}R_1\text{-}R_2\text{-}Si(R_3)_3 \qquad (i),$$

wherein $R_f$ is a perfluoropolyoxyalkyl group or a perfluoro polyoxyalkylene group, $R_1$ is either an amide group, an ester group or a methyl ether group, $R_2$ is either a $C_{2\text{-}5}$ alkylene group or an amino-substituted $C_{2\text{-}5}$ alkylene group, and $R_3$ is a $C_{1\text{-}3}$ alkoxy group, wherein one of $R_3$ of the silanol group may be methyl.

Concrete examples of the fluorinated compounds having a terminal silanol group are the following substances :

(1) $R_f\text{-}CONH\text{-}C_3H_6\text{-}Si(OC_2H_5)_3$

(2) $R_f\text{-}CONH\text{-}C_2H_4NHC_3H_6\text{-}Si(OCH_3)_2(CH_3)$

(3) $R_f\text{-}CONH\text{-}C_2H_4NHC_3H_6\text{-}Si(OCH_3)_3$

(4) $R_f\text{-}CH_2O\text{-}C_3H_6\text{-}Si(OCH_3)_3$

(5) $R_f\text{-}COO\text{-}C_3H_6\text{-}OC_3H_6\text{-}Si(OCH_3)_3$

The compounds represented by the following general formulae (ii) and (iii) are also to be mentioned:

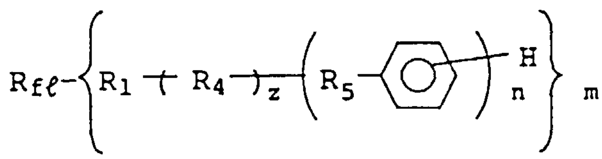 (ii),

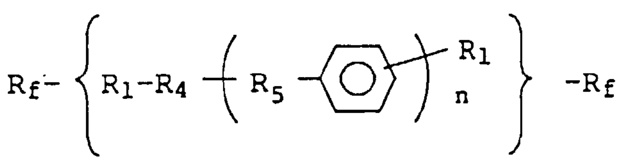 (iii),

wherein $R_f$ is a perfluoropolyoxyalkyl group or a perfluoropolyoxyalkylene group; $R_1$ is an ester group, an amide group or a methyl ether group ; $R_4$ is a $C_{2\text{-}3}$ oxyalkylene group, a phenylene group or a $C_{1\text{-}2}$ alkylene group ; $R_5$ is a single bond, an ether group, an alkyl group, an amide group or $-C(CH_3)_2-$ , and may be the same or different in the repeating units; Z is 0 or a positive integer; and n is 0 or a positive integer when $R_4$ is an oxy-alkylene group, or an integer of 1-5 when $R_4$ is not an oxyalkylene group with the provisos that $R_f$ is (a) perfluoropolyoxyalkyl when $\ell$ is 1 or 2 and m is 1, or (b) perfluoropolyoxyalkylene when $\ell$ is 1 and m is 2, and $\ell$ and m cannot be 2 at the same time.

Concrete examples are

(6) 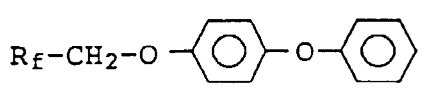

(7) 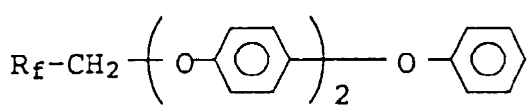

(8) 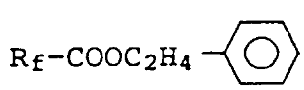

(9) 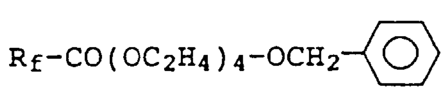

(10) 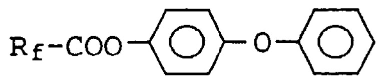

(11) 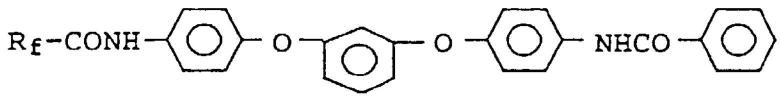

(12) 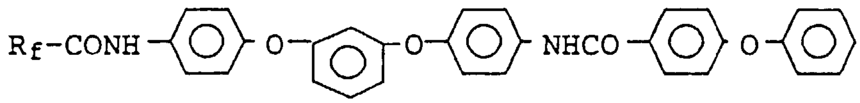

(13) 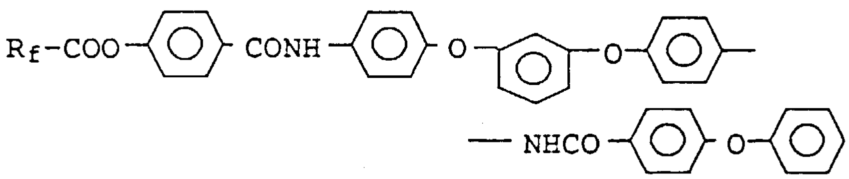

(14) 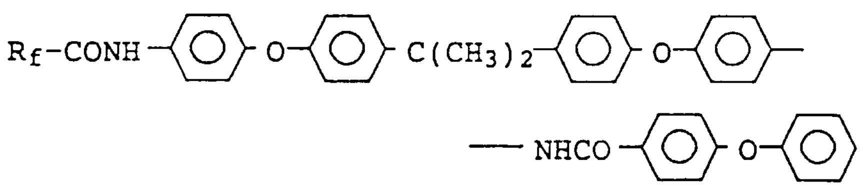

(15) 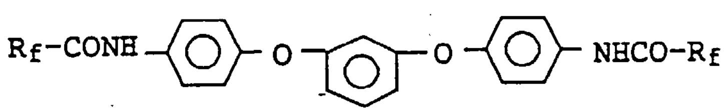

(16) 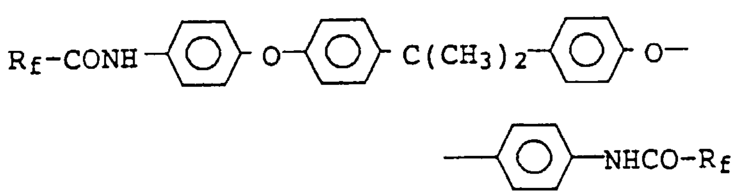

(17) 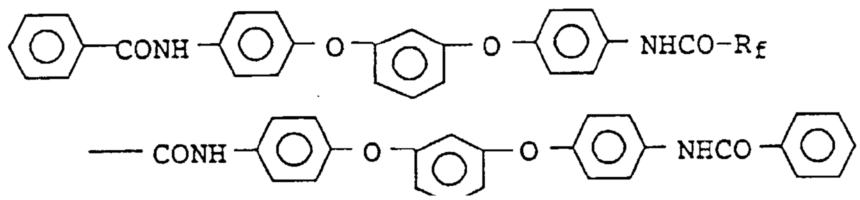

(18) $R_f$-$CO(OC_2H_4)_4OH$

(19) $R_f$-$CO(OC_2H_4)_{14}OH$

(20) $R_f$-$CO(OC_2H_4)_4OCH_3$

$R_f$ of the compounds (1) - (16) and (18) - (20) is $F(C_3F_6O)_n$ - $C_2F_4$, and n is 14 on the average. $R_f$ of the compound (17) is -$(C_3F_6O)_{33}$ - $(CF_2O)_{16}$-$CF_2$-.

Concrete examples of the fluorinated compounds are the Krytox 175 series manufactured by Du Pont Co., and the Fomblin Z series manufactured by Montecatini Co., the Krytox 175 series having a regular structure being especially preferred. Furthermore, those having even molecular weight as possible are preferred.

The addition amount of the fluorinated compounds represented by the above general formulae is not especially restricted. However, these compounds are added generally in an amount of 0.05 - 14 % by weight, and preferably 0.1 - 10 % by weight, based on the total weight of the composition. It is difficult to expect a sufficient effect of preventing the base oil from separation or bleeding in the compositions when the amount is less than 0.05 % by weight. When the amount is more than 10 % by weight, it is uneconomic.

The present invention is applied to the lubricants, i.e. so-called greases (that contain a base oil and a thickener as the essential components), but also to heat conducting materials (i.e., compositions containing the base oil, a thickener and/or a highly heat-conducting powdery filler having the function of the thickener), which are used or have recently been developed for electronical appliances and the like. The compositions of the present invention are semi-solid and exhibit non-Newtonian liquid or thixotropic properties owing to the action of the thickener. The thickener includes metal soap type, complex soap type, high molecular weight urea type and the like thickeners; an inorganic fine powders such as silicon dioxide, bentonite and the like. When the composition is required to have a high heat conductivity, a highly heat conducting inorganic filler powder is further added; if the highly heat conducting inorganic filler has a small diameter it may be added in place of the thickener.

The powdery heat conducting inorganic filler includes heat conducting compounds containing a heat conducting filler such as metal oxides having a thermal conductivity of more than 7 W/m·K, silicon carbide, boron nitride, aluminium nitride and silicon nitride, and heat conducting compounds containing a heat conducting filler in a base oil such as a mineral oil or various synthetic oils. In the case of serving both as the filler and the thickener, the powdery heat conducting filler preferably has a particle diameter as small as possible, with average an particle size of less than 1 µm, especially less than 0.5 µm being preferred.

The base oil is selected from mineral oils, various synthetic oils and the polydimethylsiloxanes, the synthetic oils being especially preferred in view of thermal stability, viscosity and the like.

Various additives may be added in order to improve the thermal stability, and the anti-rust and anti-corrosion properties of the compositions to metals.

In the prevent invention, separation, bleeding or diffusion of the base oil is reduced by the presence of the fluorinated organic compound slightly soluble in the base oil in the composition. Since the fluorinated compound used in the instant invention is not dissolved or hardly dissolved in the base oil, the fluorinated compound is present in dispersed form in the compositions, or adhering to the surface of the filler, or being in a mixed state of both. It has a barrier effect and has a function of controlling separation, bleeding or diffusion of the base oil. It has been found that the smaller the contact angle of the fluorinated compound insoluble in the base oil, the greater the effect of controlling separation, bleeding or diffusion of the base oil.

The test methods applied with regard to the prevention of separation, bleeding or diffusion of the base oil from the compositions according to the present invention are explained below.

(1) Oil separation test (JIS K 2220)

About 10 g of the composition is weighed out on a 60 mesh cone wire gauze. This is hung in a glass beaker, and left 24 hours in a constant temperature bath maintained at 150 °C. Thereafter, the amount of oil dropped into the beaker is measured to calculate the separation ratio for the composition, which ratio represents the oil separation degree.

(2) Penetration test (JIS K 2220)

Since the softer the composition is, the greater becomes the tendency of bleeding, the penetration is measured. The composition is placed in a mixing vessel and maintained at 25 °C, then worked 60 times back and forth, and immediately thereafter, the penetration is measured.

(3) Base oil diffusion test

The test method is explained with reference to Fig. 3. The composition is rendered to adhere to the point of the needle of a syringe, and then about 0.2 g of the composition 22 is coated on an aluminium nitride plate 21 (0.6 mm in thickness; 100 x 100 mm) having a maximum surface roughness of 5 µm into a circular moutain-like shape (about 4 mm in diameter). This arrangement is left in a constant temperature bath at 150 °C for 20 hours, thereafter the width (mm) of the bleeded or diffused part of the base oil 23 is measured, and this diffusion width is calculated according to the following equation:

diffusion width (mm) = diffusion amount - diameter of coated compound/2

The present invention is illustrated by the following examples in more details. The used fluorinated compounds have been selected from those listed above.

Example 1

To a composition composed of 9 % by weight of poly-α-olefin oil (Gargoyle Arctic SHC 226, manufactured by Mobil Co.) having a viscosity at 40 °C of 68.1mm$^2$/s as a base oil, and 7 % by weight of lithium 12-hydroxystearate as a thickener, there were added 2 % by weight of various fluorinated compounds shown in Table 1. The mixture was heated to 150 °C with stirring, and then gradually cooled to room temperature. This mixture was finished with three rolls. The penetration degree, the oil separation degree and the diffusion width of the base oil of the thus obtained composition were measured. The results are shown in Table 1.

Comparative Example 1

A compound composed of 7 % by weight of lithium stearate as thickener, 82 % by weight of the synthetic oil used in Example 1 as base oil and 5 % by weight of a fluorinated alkyl ester (FC-430, made by Sumitomo 3M Co.) as fluorinated surfactant was prepared.

Comparative Example 2

A composition composed of the following components was prepared.

| | |
|---|---|
| thickener: | 10 % by weight of lithium 12-hydroxystearate base oil: |
| base oil : | 85 % by weight of mineral oil having a viscosity at 40 °C of 110 mm$^2$/s fluorinated surfactant: 5 % by weight of the surfactant used in Comparative Example 1 |

Comparative Example 3

A composition composed of the following components was prepared.

| | |
|---|---|
| thickener: | 10 % by weight of lithium 12-hydroxystearate, |
| base oil: | 80 % by weight of diethylhexylsebacate (synthetic oil having a viscosity at 40 °C of 11.0 mm$^2$/s) |
| fluorinated surfactant: | 10 % by weight of a perfluoroalkyl carboxylic acid. |

Comparative Example 4

A heat conducting composition composed of the following components was prepared.

| | |
|---|---|
| heat conducting powder: | 50 % by weight of zinc oxide (0.5 μm average particle diameter) |
| base oil: | 50 % by weight of a polydimethylsiloxane oil having a viscosity at 25° C of 350.0 $mm^2/s$ |

Comparative Example 5

A heat conducting composition composed of the following components was prepared.

| | |
|---|---|
| heat conducting powder: | 50 % by weight of BN (boron nitride GP, 0.5 μm average particle diameter) |
| base oil: | 50% by weight of a perfluorinated polyether (Fomblin Y-45, made by Montecatini Co.) having a viscosity at 40 °C of 150.0 $mm^2/s$ |

Table 1

| Compound No. | Penetration after working | Oil separation (wt.%) (150 °C, 24 h) | Diffusion width (mm) (150 °C, 15 h) |
|---|---|---|---|
| 1 | 335 | 0 | 0 |
| 2 | 340 | 0 | 0 |
| 3 | 341 | 0 | 0 |
| 4 | 338 | 0 | 0.4 |
| 5 | 339 | 0 | 0 |
| 6 | 310 | 0.01 | 1.7 |
| 7 | 305 | 0.01 | 1.9 |
| 8 | 320 | 0.02 | 1.1 |
| 9 | 325 | 0.03 | 1.0 |
| 10 | 310 | 0.03 | 2.4 |
| 11 | 328 | 0 | 0 |
| 13 | 310 | 0.01 | 2.3 |
| 14 | 300 | 0.02 | 3.5 |
| 15 | 299 | 0.01 | 2.5 |
| 17 | 287 | 0.01 | 1.8 |
| Comparative Example 1 | 340 | 5.8 | 62.5 |
| " 2 | 348 | 6.2 | 32.4 |
| " 3 | 341 | 7.6 | 40.6 |
| " 4 | 305 | 9.8 | 28.4 |
| " 5 | 299 | 6.0 | 55.3 |

Example 2

To a composition composed of 7 % by weight of lithium stearate (thickener) in a poly-α-olefin oil (base oil) having a viscosity at 40° C of 68.1 $mm^2/s$ were added 2 % by weight of various fluorinated compounds shown in Table 2. The mixture was heated to 150 °C with stirring and then gradually cooled to room temperature. This mixture was finished with three rolls. The penetration degree, the oil separation degree, and the diffusion width of the base oil of the thus obtained composition were measured. The results are shown in Table 2.

Table 2

| Compound No. | Penetration after working | Oil separation (wt.%) (150 °C, 24 h) | Diffusion width (mm) (150 °C, 15 h) |
|---|---|---|---|
| 1 | 332 | 0 | 0 |
| 2 | 336 | 0 | 0 |
| 3 | 320 | 0 | 0 |
| 4 | 340 | 0 | 0.3 |
| 5 | 338 | 0 | 0 |
| 6 | 310 | 0 | 1.6 |
| 7 | 315 | 0 | 1.7 |
| 8 | 318 | 0.01 | 0.9 |
| 9 | 322 | 0 | 0.8 |
| 10 | 330 | 0.01 | 2.5 |
| 11 | 327 | 0 | 0 |
| 13 | 325 | 0 | 2.3 |
| 14 | 317 | 0 | 3.7 |
| 15 | 310 | 0 | 2.6 |
| 17 | 308 | 0 | 2.0 |

Example 3

To a composition composed of 10 % by weight of a high molecular urea compound (thickener) obtained by reacting a diisocyanate with a diamine in a mineral oil (base oil) having a viscosity at 40 °C of 110.0 $mm^2/s$ were added 2 % by weight of various fluorinated compounds shown in Table 3. The mixture was heated to 150 °C with stirring, and then gradually cooled to room temperature. This mixture was finished with three rolls. The penetration degree, the oil separation degree and the diffusion width of the base oil of the thus obtained composition were measured. The results are shown in Table 3.

Table 3

| Compound No. | Penetration after working | Oil separation (wt.%) (150 °C, 24 h) | Diffusion width (mm) (150 °C, 15 h) |
|---|---|---|---|
| 1 | 280 | 0 | 0 |
| 2 | 265 | 0 | 0 |
| 3 | 275 | 0 | 0 |
| 4 | 285 | 0 | 0 |
| 5 | 281 | 0 | 0 |
| 6 | 271 | 0 | 0.9 |
| 7 | 250 | 0 | 1.2 |
| 8 | 262 | 0.02 | 1.8 |
| 9 | 268 | 0 | 1.0 |
| 10 | 255 | 0 | 0 |
| 11 | 260 | 0 | 2.0 |
| 13 | 253 | 0 | 2.5 |

Table 3 (continued)

| Compound No. | Penetration after working | Oil separation (wt.%) (150 °C, 24 h) | Diffusion width (mm) (150 °C, 15 h) |
|---|---|---|---|
| 14 | 258 | 0 | 1.9 |
| 15 | 263 | 0 | 1.0 |
| 17 | 250 | 0 | 1.4 |

Example 4

To a heat conducting composition composed of 50 % by weight of zinc oxide powder (0.5 µm average particle diameter) in polydimethylsiloxane (base oil) having a viscosity at 25 °C of 350.0 $mm^2$ were added 1.15 % by weight of the fluorinated compounds shown in Table 4. The mixture was heated to 200 °C with stirring, then gradually cooled to room temperature, and finished with three rolls. The penetration degree, the oil separation degree and the diffusion width of the base oil of the heat conducting composition thus obtained were measured. The results are shown in Table 4.

Table 4

| Compound No. | Penetration after working | Oil separation (wt.%) (150 °C, 24 h) | Diffusion width (mm) (150 °C, 15 h) |
|---|---|---|---|
| 1 | 240 | 0 | 0.2 |
| 2 | 232 | 0 | 0.1 |
| 3 | 245 | 0 | 0.2 |
| 4 | 255 | 0 | 0.5 |
| 5 | 235 | 0 | 0.1 |
| 6 | 260 | 0.05 | 2.0 |
| 7 | 270 | 0.06 | 2.3 |
| 8 | 260 | 0.03 | 2.1 |
| 9 | 283 | 0.04 | 1.8 |
| 10 | 250 | 0.07 | 2.7 |
| 11 | 346 | 0.03 | 1.2 |
| 13 | 368 | 0.03 | 2.6 |
| 14 | 289 | 0.01 | 2.1 |
| 15 | 358 | 0.01 | 1.9 |
| 17 | 330 | 0.02 | 2.0 |

Comparative Example 6

A heat conducting composition composed of 50 % by weight of zinc oxide powder (0.5 µm in average particle diameter) in perfluoro polyether oil (Krytox 143AD, manufactured by Du Pont Co.) (base oil) having a viscosity at 40 °C of 80 $mm^2/s$ was added 1.15 % by weight of the fluorine based compounds shown in Table 5. The mixture was heated to 200 °C with stirring, then gradually cooled to room temperature, and finished with three rolls. The penetration degree, the oil separation degree and the diffusion width of the base oil of the heat conducting composition thus obtained were measured. The results are shown in Table 5.

As is clear from the Tables of these Examples, the compositions and heat conducting compositions of the instant invention have quite small values of the oil separation degree and the diffusion of the base oil. In contrast thereto , conventional compositions have large values of the oil separation degree and the diffusion of the base oil.

Table 5

| Compound No. | Penetration after working | Oil separation (wt.%) (150 °C, 24 h) | Diffusion width (mm) (150 °C, 15 h) |
|---|---|---|---|
| 1 | 258 | 0.01 | 0.3 |
| 2 | 230 | 0.01 | 0.3 |
| 3 | 220 | 0.02 | 0.2 |
| 4 | 242 | 0.05 | 0.5 |
| 5 | 220 | 0.04 | 0.7 |
| 6 | 267 | 0.20 | 1.1 |
| 7 | 250 | 0.10 | 1.8 |
| 8 | 245 | 0.15 | 1.8 |
| 9 | 231 | 0.13 | 1.5 |
| 10 | 250 | 0.16 | 2.0 |
| 11 | 270 | 0.03 | 0.7 |
| 13 | 368 | 0.08 | 0.8 |
| 14 | 270 | 0.04 | 0.4 |
| 15 | 280 | 0.08 | 0.6 |
| 17 | 292 | 0.04 | 0.5 |

Example 5

The penetration degree, the oil separation degree and the diffusion state of the oil were measured with heat conducting compositions composed of 40 % by weight of zinc oxide powder (0.5 µm average particle diameter) in polydimethylsiloxane (base oil) having a viscosity at 25 °C of 350.0 $mm^2/s$ and 0.01 - 16 % by weight of the fluorinated compounds Nos. 1, 8, 11 and 17. The results are shown in Table 6. As is clear from Table 6, the oil separation degree and the diffusion of the oil are lowered when the content of the fluorinated compound is 0.05% by weight or more. The workability in coating of the composition is deteriorated when the penetration degree is lowered (the composition becomes hard).

Table 6

| Compound No. | Item | Addition amount (wt. %) | | | | | | |
|---|---|---|---|---|---|---|---|---|
| | | 0.01 | 0.05 | 1.0 | 5.0 | 10.0 | 14.0 | 16.0 |
| 1 | Penetration after working | 246 | 255 | 238 | 240 | 220 | 213 | 200 |
| | Oil separation (wt.%) | 6.5 | 3.3 | 0.02 | 0 | 0 | 0 | 0 |
| | Diffusion width (mm) | 18.2 | 6.5 | 0.6 | 0 | 0 | 0 | 0 |
| 8 | Penetration after working | 275 | 280 | 268 | 255 | 247 | 233 | 215 |
| | Oil separation (wt.%) | 7.5 | 3.8 | 0.05 | 0 | 0 | 0 | 0 |
| | Diffusion width (mm) | 20.1 | 7.0 | 3.4 | 0.6 | 0 | 0 | 0 |
| 11 | Penetration after working | 360 | 360 | 355 | 347 | 330 | 310 | 295 |
| | Oil separation (wt.%) | 7.8 | 3.5 | 0.07 | 0 | 0 | 0 | 0 |
| | Diffusion width (mm) | 21.0 | 7.2 | 4.5 | 0.3 | 0 | 0 | 0 |
| 17 | Penetration after working | 340 | 346 | 335 | 330 | 318 | 310 | 285 |
| | Oil separation (wt.%) | 7.0 | 3.0 | 0.06 | 0 | 0 | 0 | 0 |
| | Diffusion width (mm) | 19.5 | 5.8 | 3.5 | 0.8 | 0 | 0 | 0 |

Example 6

5 g of the fluorinated compounds Nos.1, 5, 6, 11, 14 and 17 were dissolved in trifluorotrichloroethane, and then thereto were added 10 g of zinc oxide powder (0.5 µm average particle diameter). After trifluorotrichloroethane was evaporated, surface treatment was carried out by heating at 200 °C for 30 minutes, and then it was ground. 50 % by weight of this zinc oxide powder were mixed with 50 % by weight of polydimethylsiloxane having the same viscosity as in Example 4; the composition was then finished with three rolls. The penetration degree and the diffusion width of the base oil of the heat conducting composition thus obtained were measured. The results are shown in Table 7.

As is clear from Table 7, bleeding or diffusion of the base oil can also be prevented by pretreating the surface of the heat conducting filler.

Table 7

| Compound No. | Penetration after working | Diffusion width (mm) (150 °C, 15 h) |
|---|---|---|
| 1 | 345 | 0 |
| 5 | 335 | 0.7 |
| 6 | 320 | 2.2 |
| 11 | 325 | 1.5 |
| 14 | 313 | 4.1 |
| 17 | 300 | 1.9 |

Example 7

Figure 1 and Figure 2 are cross-sectional views of one example which simulates a cooling structure used to evaluate bleeding or diffusion of the base oil of the heat conducting composition of Example 6 containing the fluorinated compounds of the instant invention. The whole structure is constituted by a heat dissipator 11 made of aluminium or copper, heat conducting blocks 12 and 13 made of aluminium nitride, a semiconductor chip 14 and a substrate board 15 made of aluminium nitride. The heat conducting composition 16 was filled between the contact surface of the heat dissipator 11 and the semiconductor chip 14, between that of the heat dissipator 11 and the heat conducting blocks 12, 13, and between that of the heat conducting block 13 and the semiconductor chip 14. The heat conducting composition 16 was coated in a thickness of 0.1 mm between the heat dissipator 11, the heat conducting blocks 12 and 13 and the semiconductor chip 14. This arrangement was left in a constant temperature bath at 150 °C for 24 hours, and then the bleeding or diffusion state of the base oil was observed. The results are shown in Table 8. As is clear from Table 8, it is found that the heat conducting composition containing the fluorinated compound of the present invention causes much less bleeding or diffusion of the base oil as compared with the Comparative Examples.

Table 8

| Compound No. | Penetration after working | Diffusion width (mm) (150 °C, 24 h) |
|---|---|---|
| 1 | 345 | no bleeding |
| 5 | 335 | " |
| 6 | 320 | " |
| 11 | 325 | " |
| 14 | 313 | " |
| 17 | 300 | " |
| Comparative Example 1 | 340 | much bleeding |
| " 3 | 341 | " |

Moreover, since these fluorinated compounds have oleophobic properties vis-à-vis the lubricating oil, the surface treatment with the fluorinated compound has the side effect to prevent bleeding or diffusion of the lubricating oil.

Since the compositions used according to the present invention are far less in the oil separation degree and the diffusion width of the base oil, the compositions are suitable for the precision appliance field, for example, for use such for sliding parts, bearings, switches, electrical contacts and the like in cameras, watches, copying machines, printers,

and the like. Furthermore, they are suitable as heat conducting compositions used for heat transmission of cooling structures or electronical parts in computers. cooling structures or electronical parts in computers.

## Claims

**1.** Electrical and electronical appliances, comprising sliding parts and a lubricant provided therebetween, the lubricant being a composition comprising

- a non-fluorinated base oil selected from mineral oils, synthetic oils, and polydimethylsiloxanes,
- a powdery heat conducting inorganic filler selected from metal oxides, silicon carbide, silicon nitride, boron nitride and aluminium nitride, and
- a fluorinated organic compound comprising one or more perfluoropolyoxyalkyl groups or perfluoropolyoxyalkylene groups and a non-fluorinated group,

characterized in that
the lubricant is a composition wherein the fluorinated organic compound has the general formula

$$(R_f)_n - X ,$$

wherein

$R_f$ is perfluoropolyoxyalkyl or perfluoropolyoxyalkylene,
X is a non-fluorinated organic group,
and
n is 1 or 2.

**2.** Electrical and electronical appliances, comprising

- a heat source (14),
- a heat sink (11) for conducting heat from the heat source (14) to the outside, and
- a heat conducting material (16) being a composition comprising
  - a non-fluorinated base oil selected from mineral oils, synthetic oils, and polydimethylsiloxanes,
  - a powdery heat conducting inorganic filler selected from metal oxides, silicon carbide, silicon nitride, boron nitride and aluminium nitride, and
  - a fluorinated organic compound comprising one or more perfluoropolyoxyalkyl groups or perfluoropolyoxyalkylene groups and a non-fluorinated group,

characterized in that
the heat conducting composition is a composition wherein the fluorinated organic compound has the general formula

$$(R_f)_n - X,$$

wherein

$R_f$ is perfluoropolyoxyalkyl or perfluoropolyoxyalkylene,
X is a non-fluorinated organic group,
and
n is 1 or 2 .

**3.** Electrical and electronical appliances according to claim 1 and/or 2,

characterized in that
the fluorinated organic compound is at least one of the compounds represented by the following general formulae:

(i) $R_f\text{-}R_1\text{-}R_2\text{-}Si(R_3)_3$

(ii) 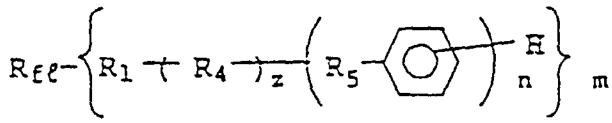

(iii) 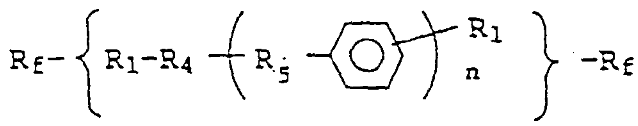

wherein are:

$R_f$ perfluoropolyoxyalkyl or perfluoropolyoxyalkylene,
$R_1$ an ester group, an amide group or a methyl ether group
$R_2$ $C_{2\text{-}5}$-alkylene or amino substituted $C_{2\text{-}5}$-alkylene,
$R_3$ $C_{1\text{-}3}$-alkoxy, wherein one of $R_3$ of the silanol group may be methyl,
$R_4$ $C_{2\text{-}3}$-oxyalkylene, $C_{1\text{-}2}$-alkylene or phenylene,
$R_5$ a single bond, an ether group, an amide group, alkylene or $\text{-}C(CH_3)_2\text{-}$, and being the same or different in the repeating units;
Z 0 or a positive integer,
n (a) 0 or a positive integer when $R_4$ is oxyalkylene,
and
(b) an integer of 1-5 when $R_4$ is not oxyalkylene,
and

l and m 1 or 2,

with the provisos that

$R_f$ is

(a) perfluoropolyoxyalkyl when l is 1 or 2, and m is 1,
and
(b) perfluoropolyoxyalkylene when l is 1, and m is 2,

and
l and mcannot be 2 at the same time.

**4.** Electrical and electronical appliances according to one or several of claims 1 to 3,
characterized in that
the fluorinated organic compound is present in an amount of 0.05 to 14 % by mass, and preferably of 0.05 to 10 % by mass, based on the total mass of the composition.

**5.** Electrical and electronical appliances according to one or several of claims 1 to 4,
characterized in that
the fluorinated organic compound is selected from

(1) $R_f\text{-}CONH\text{-}C_3H_6\text{-}Si(OC_2H_5)_3$

(2) $R_f\text{-CONH-}C_2H_4NHC_3H_6\text{-Si}(OCH_3)_2(CH_3)$

(3) $R_f\text{-CONH-}C_2H_4NHC_3H_6\text{-Si}(OCH_3)_3$

(4) $R_f\text{-}CH_2O\text{-}C_3H_6\text{-Si}(OCH_3)_3$

(5) $R_f\text{-COO-}C_3H_6\text{-}OC_3H_6\text{-Si}(OCH_3)_3$

(6) 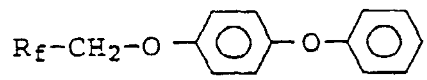

(7) 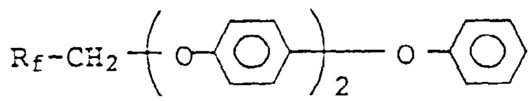

(8) 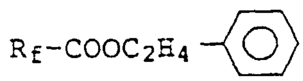

(9) 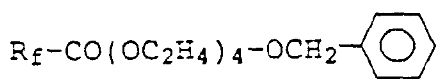

(10) 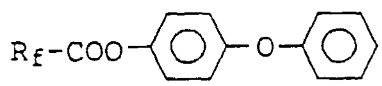

(11) 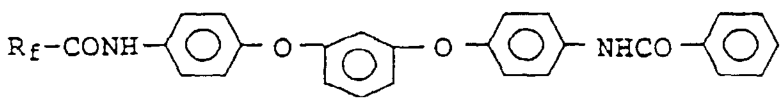

(12) 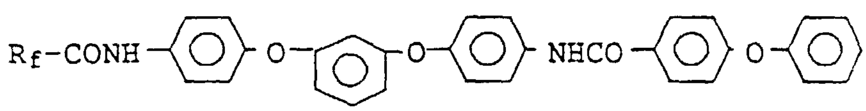

(13) 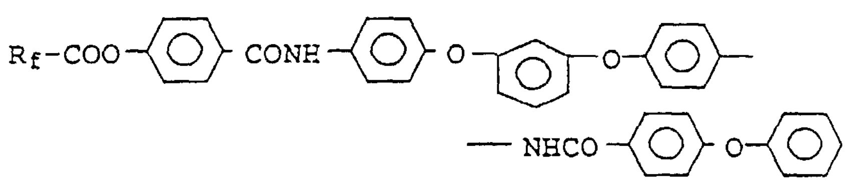

(14) 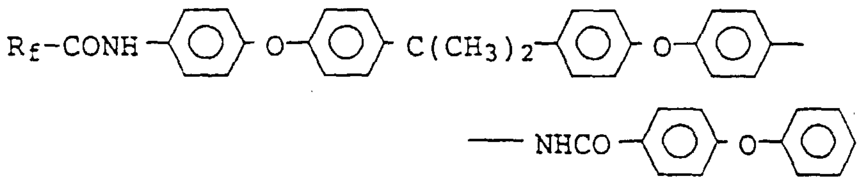

(15) 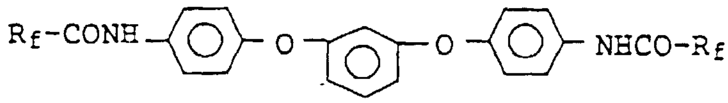

(16) 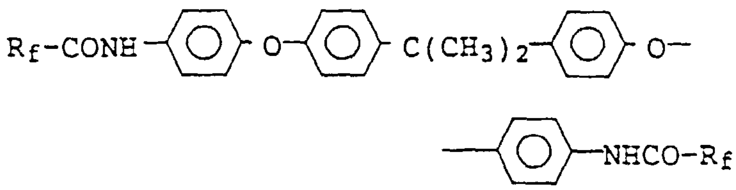

(17) 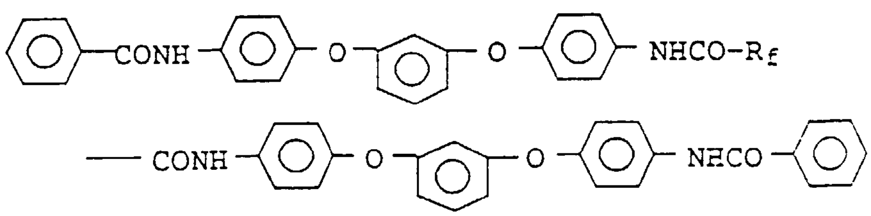

(18) $R_f\text{-}CO(OC_2H_4)_4OH$

(19) $R_f\text{-}CO(OC_2H_4)_{14}OH$

and

(20) $R_f\text{-}CO(OC_2H_4)_4OCH_3$,

wherein $R_f$ is
$F(C_3F_6O)_n\text{-}C_2F_4\text{-}$ in compounds (1) - (16) and (18) - (20),
and
$\text{-}(C_3F_6O)_{33}\text{-}(CF_2O)_{16}\text{-}CF_2\text{-}$ in compound (17),
and
n is 14 on the average.

**6.** Electrical and electronical appliances according to one or several of claims 1 to 5, characterized in that the groups $R_f$ of the fluorinated organic compounds are terminal groups.

**7.** Electrical and electronical appliances according to one or several of claims 1 to 6,

characterized in that
the heat conducting inorganic filler is a metal oxide having a thermal conductivity of more than 7 W/m·K.

**8.** Electrical and electronical appliances according to one or several of claims 1 to 7,
characterized in that the heat conducting inorganic filler is zinc oxide.

**9.** Electrical and electronical appliances according to one or several of claims 1 to 8,
characterized in that the base oil is a poly-$\alpha$-olefin oil.

**10.** Electrical and electronical appliances according to one or several of claims 1 to 9,
characterized in that
the fluorinated organic compound is present in the composition in an amount of 0.05 to 14 % by weight, and preferably of 0.1 to 10 % by weight, based on the total weight of the composition.

**Patentansprüche**

**1.** Elektrische und elektronische Vorrichtungen,
mit gleitenden Teilen und einem dazwischen befindlichen Schmiermittel,
wobei das Schmiermittel eine Zusammensetzung ist, die enthält:

- ein nicht fluoriertes Basisöl, das aus Mineralölen, synthetischen Ölen und Polydimethylsiloxanen ausgewählt ist,
- einen pulverförmigen, wärmeleitenden, anorganischen Füllstoff, der aus Metalloxiden, Siliciumcarbid, Siliciumnitrid, Bornitrid und Aluminiumnitrid ausgewählt ist, und
- eine fluorierte organische Verbindung, die eine oder mehr Perfluorpolyoxyalkyl-Gruppen oder Perfluorpolyoxyalkylen-Gruppen und eine nicht fluorierte Gruppe enthält,

dadurch gekennzeichnet, daß
das Schmiermittel eine Zusammensetzung ist, in der die fluorierte organische Verbindung die allgemeine Formel

$$(R_f)_n - X$$

besitzt,
wobei

$R_f$ Perfluorpolyoxyalkyl oder Perfluorpolyoxyalkylen ist,
X eine nicht fluorierte organische Gruppe ist und
n 1 oder 2 ist.

**2.** Elektrische und elektronische Vorrichtungen, mit

- einer Wärmequelle (14),
- einem Kühlkörper (11), der Wärme von der Wärmequelle (14) nach außen leitet, und
- einem wärmeleitenden Material (16), dessen Zusammensetzung enthält:
    - ein nicht fluoriertes Basisöl, das aus Mineralölen, Synthetikölen und Polydimethylsiloxanen ausgewählt ist,
    - einen pulverförmigen, wärmeleitenden, anorganischen Füllstoff, der aus Metalloxiden, Siliciumcarbid, Siliciumnitrid, Bornitrid und Aluminiumnitrid ausgewählt ist, und
    - eine fluorierte organische Verbindung, die eine oder mehr Perfluorpolyoxyalkyl-Gruppen oder Perfluorpolyoxyalkylen-Gruppen und eine nicht fluorierte Gruppe enthält,

dadurch gekennzeichnet, daß
die wärmeleitende Zusammensetzung eine Zusammensetzung ist, in der die fluorierte organische Verbindung die allgemeine Formel

$(R_f)_n - X$

besitzt,
wobei

$R_f$ Perfluorpolyoxyalkyl oder Perfluorpolyoxyalkylen ist,
X eine nicht fluorierte organische Gruppe ist und
n 1 oder 2 ist.

**3.** Elektrische und elektronische Vorrichtung nach Anspruch 1 und/oder 2,
dadurch gekennzeichnet, daß
die fluorierte organische Verbindung wenigstens eine der Verbindungen ist, die durch die folgenden allgemeinen Formeln dargestellt werden:

(i) $R_f\text{-}R_1\text{-}R_2\text{-}Si(R_3)_3$

(ii) 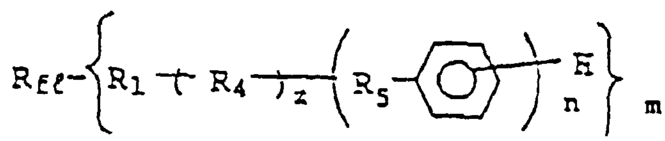

(iii) 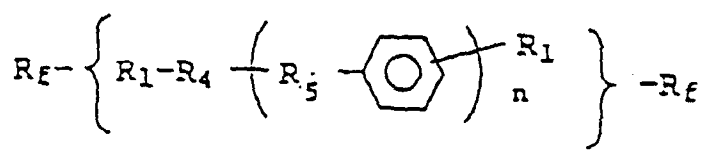

wobei

$R_f$ Perfluorpolyoxyalkyl oder Perfluorpolyoxyalkylen ist,
$R_1$ eine Ester-Gruppe, eine Amid-Gruppe oder eine Methylether-Gruppe ist,
$R_2$ $C_{2\text{-}5}$-Alkylen oder aminosubstituiertes $C_{2\text{-}5}$-Alkylen ist,
$R_3$ $C_{1\text{-}3}$-Alkoxy ist, wobei einer von $R_3$ der Silanol-Gruppe Methyl sein kann,
$R_4$ $C_{2\text{-}3}$-Oxyalkylen, $C_{1\text{-}2}$-Alkylen oder Phenylen ist,
$R_5$ eine einfache Bindung, eine Ether-Gruppe, eine Amid-gruppe, Alkylen oder $-C(CH_3)_2-$ ist und in den sich wiederholenden Einheiten gleich oder unterschiedlich ist;
Z 0 oder eine positive ganze Zahl ist,
n (a) 0 oder eine positive ganze Zahl ist, wenn $R_4$ Oxyalkylen ist, und
(b) eine ganze Zahl von 1-5 ist, wenn $R_4$ nicht Oxyalkylen ist,

und
l, m 1 oder 2 sind,

mit den Bedingungen, daß $R_f$

(a) Perfluorpolyoxyalkyl ist, wenn 1 gleich 1 oder 2 ist und m gleich 1 ist, und
(b) Perfluorpolyoxyalkylen ist, wenn 1 gleich 1 ist und m gleich 2 ist, und

l, m nicht gleichzeitig gleich 2 sein können.

**4.** Elektrische und elektronische Vorrichtungen nach einem oder mehreren der Ansprüche 1 bis 3,
dadurch gekennzeichnet, daß
die fluorierte organische Verbindung in einer Menge von 0,05 bis 14 Massen-% und vorzugsweise von 0,05 bis 10 Massen-%, bezogen auf die Gesamtmasse der Zusammensetzung, vorliegt.

**5.** Elektrische und elektronische Vorrichtungen nach einem oder mehreren der Ansprüche 1 bis 4, dadurch gekennzeichnet, daß die fluorierte organische Verbindung ausgewählt ist aus

(1) $R_f\text{-CONH-}C_3H_6\text{-Si}(OC_2H_5)_3$

(2) $R_f\text{-CONH-}C_2H_4NHC_3H_6\text{-Si}(OCH_3)_2(CH_3)$

(3) $R_f\text{-CONH-}C_2H_4NHC_3H_6\text{-Si}(OCH_3)_3$

(4) $R_f\text{-}CH_2O\text{-}C_3H_6\text{-Si}(OCH_3)_3$

(5) $R_f\text{-COO-}C_3H_6\text{-}OC_3H_6\text{-Si}(OCH_3)_3$

(6) 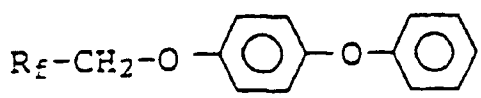

(7) 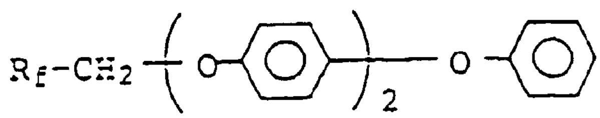

(8) 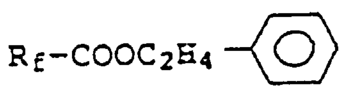

(9) 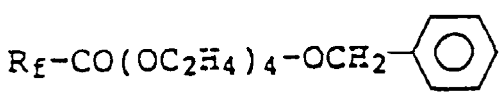

(10) 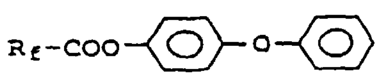

(11) 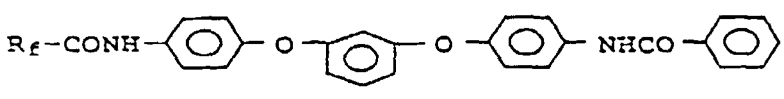

(12) 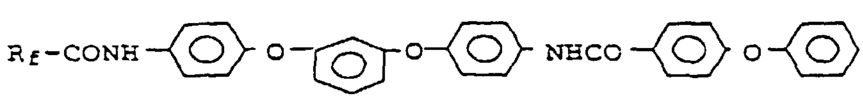

(13) 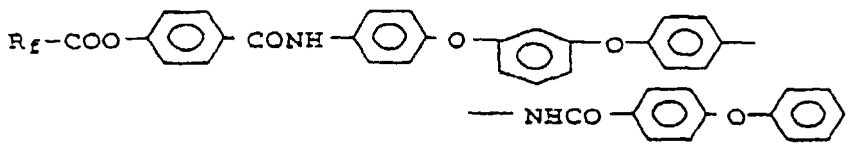

(14) 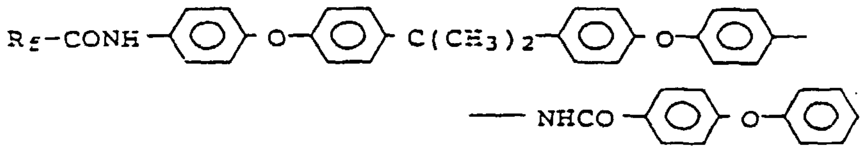

(15) 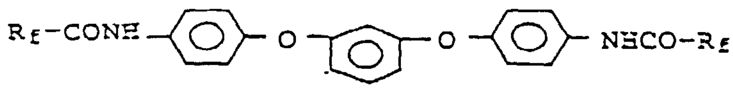

(16) 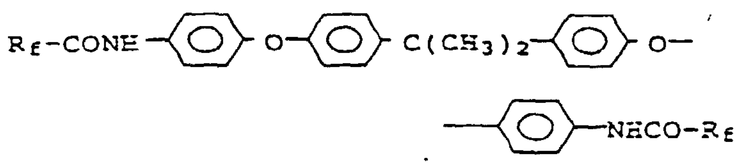

(17) 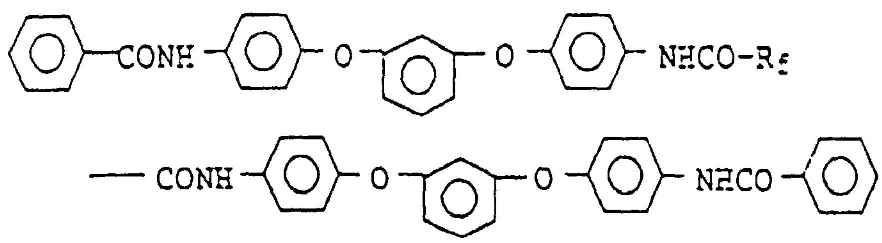

(18) $R_f\text{-}CO(OC_2H_4)_4OH$

(19) $R_f\text{-}CO(OC_2H_4)_{14}OH$

und

(20) $R_f\text{-}CO(OC_2H_4)_4OCH_3$,

wobei $R_f$

in den Verbindungen (1)-(16) und (18)-(20) gegeben ist durch $F(C_3F_6O)_n\text{-}C_2F_4\text{-}$ und in der Verbindung (17) durch $-(C_3F_6O)_{33}\text{-}(CF_2O)_{16}\text{-}CF_2\text{-}$gegeben ist und n im Durchschnitt 14 ist.

6. Elektrische und elektronische Vorrichtung nach einem oder mehreren der Ansprüche 1 bis 5, dadurch gekennzeichnet, daß die Gruppen $R_f$ der fluorierten organischen Verbindungen Endgruppen sind.

7. Elektrische und elektronische Vorrichtungen nach einem oder mehreren der Ansprüche 1 bis 6, dadurch gekennzeichnet, daß der wärmeleitende, anorganische Füllstoff ein Metalloxid mit einer Wärmeleitfähigkeit von mehr als 7 W/m ·K ist.

8. Elektrische und elektronische Vorrichtungen nach einem oder mehreren der Ansprüche 1 bis 7, dadurch gekennzeichnet, daß der wärmeleitende, anorganische Füllstoff Zinkoxid ist.

9. Elektrische und elektronische Vorrichtungen nach einem oder mehreren der Ansprüche 1 bis 8, dadurch gekennzeichnet, daß das Basisöl ein Poly-α-Olefin-Öl ist.

10. Elektrische und elektronische Vorrichtungen nach einem oder mehreren der Ansprüche 1 bis 9, dadurch gekennzeichnet, daß die fluorierte organische Verbindung in der Zusammensetzung in einer Menge von 0,05 bis 14 Gew.-% und vorzugsweise von 0,1 bis 10 Gew.-%, bezogen auf das Gesamtgewicht der Zusammensetzung, vorliegt.

**Revendications**

1. Appareils électriques et électroniques, comprenant des pièces coulissantes et un lubrifiant fourni entre celles-ci, le lubrifiant étant une composition comprenant

   - une huile de base non fluorée choisie parmi les huiles minérales, les huiles synthétiques et les polydiméthylsiloxanes,
   - une charge inorganique thermoconductrice en poudre choisie parmi les oxydes de métal, le carbure de silicium, le nitrure de silicium, le nitrure de bore et le nitrure d'aluminium, et
   - un composé organique fluoré comprenant un ou plusieurs groupes perfluoropolyoxyalkyles ou groupes perfluoropolyoxyalkylènes et un groupe non fluoré,

   caractérisés en ce que le lubrifiant est une composition dans laquelle le composé organique fluoré a la formule générale

$$(R_f)_n\text{-}X,$$

   dans laquelle $R_f$ est un groupe perfluoropolyoxyalkyle ou perfluoropolyoxyalkylène, X est un groupe organique non fluoré et n est 1 ou 2.

2. Appareils électriques et électroniques, comprenant

   - une source de chaleur (14),
   - un puits de chaleur (11) pour conduire la chaleur depuis la source de chaleur (14) jusqu'à l'extérieur, et
   - une matière thermoconductrice (16) qui est une composition comprenant
   - une huile de base non fluorée choisie parmi les huiles minérales, les huiles synthétiques et les polydiméthylsiloxanes,
   - une charge inorganique thermoconductrice en poudre choisie parmi les oxydes de métal, le carbure de silicium, le nitrure de silicium, le nitrure de bore et le nitrure d'aluminium, et
   - un composé organique fluoré comprenant un ou plusieurs groupes perfluoropolyoxyalkyles ou groupes perfluoropolyoxyalkylènes et un groupe non fluoré,

   caractérisés en ce que la composition thermoconductrice est une composition dans laquelle le composé organique fluoré a la formule générale

$$(R_f)_n\text{-}X,$$

dans laquelle $R_f$ est un groupe perfluoropolyoxyalkyle ou perfluoropolyoxyalkylène, X est un groupe organique non fluoré et n est 1 ou 2.

**3.** Appareils électriques et électroniques selon la revendication 1 et/ou 2, caractérisés en ce que le composé organique fluoré est au moins l'un des composés représentés par les formules générales suivantes :

(i) $R_f\text{-}R_1\text{-}R_2\text{-}Si(R_3)_3$

(ii) 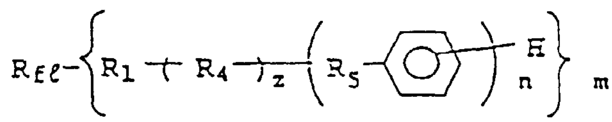

(iii) 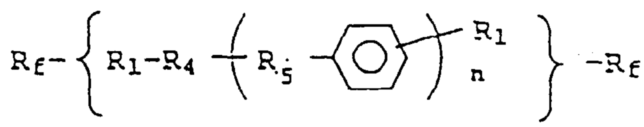

dans lesquelles :

$R_f$ est un groupe perfluoropolyoxyalkyle ou perfluoropolyoxyalkylène,
$R_1$ est un groupe ester, un groupe amide ou un groupe éther de méthyle
$R_2$ est un groupe alkylène en $C_2$ à $C_5$ ou un groupe alkylène en $C_2$ à $C_5$ amino-substitué,
$R_3$ est un groupe alcoxy en $C_1$ à $C_3$, l'un de $R_3$ du groupe silanol pouvant être un groupe méthyle,
$R_4$ est un groupe oxyalkylène en $C_2$ à $C_3$, alkylène en $C_1$ à $C_2$ ou phénylène,
$R_5$ est une liaison simple, un groupe éther, un groupe amide, alkylène ou $-C(CH_3)_2-$ et est identique ou différent dans les unités répétées ;
Z est 0 ou nombre entier positif,
n (a) est 0 ou un nombre entier positif lorsque $R_4$ est un groupe oxyalkylène, et
(b) est un nombre entier de 1 à 5 lorsque $R_4$ n'est pas un groupe oxyalkylène, et

l et m sont 1 ou 2,
avec les conditions que $R_f$ soit

(a) un groupe perfluoropolyoxyalkyle lorsque l est l ou 2 et m est 1, et
(b) un groupe perfluoropolyoxyalkylène lorsque 1 est 1 et m est 2, et que
l et m ne puissent pas être 2 en même temps.

**4.** Appareils électriques et électroniques selon une ou plusieurs des revendications 1 à 3, caractérisés en ce que le composé organique fluoré est présent en une proportion de 0,05 à 14 % en masse, et de préférence de 0,05 à 10 % en masse, sur la base de la masse totale de la composition.

**5.** Appareils électriques et électroniques selon une ou plusieurs des revendications 1 à 4, caractérisés en ce que le composé organique fluoré est choisi parmi

(1) $R_f\text{-CONH-}C_3H_6\text{-Si}(OC_2H_5)_3$

(2) $R_f\text{-CONH-}C_2H_4NHC_3H_6\text{-Si}(OCH_3)_2(CH_3)$

(3) $R_f\text{-CONH-}C_2H_4NHC_3H_6\text{-Si}(OCH_3)_3$

(4) $R_f-CH_2O-C_3H_6-Si(OCH_3)_3$

(5) $R_f-COO-C_3H_6-OC_3H_6-Si(OCH_3)_3$

(6) 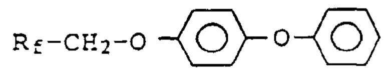

(7) 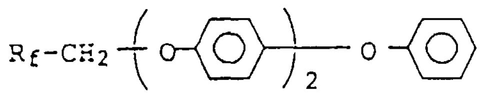

(8) 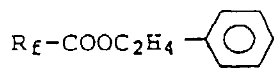

(9) 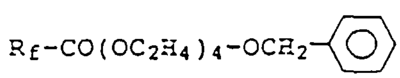

(10) 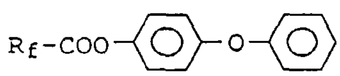

(11) 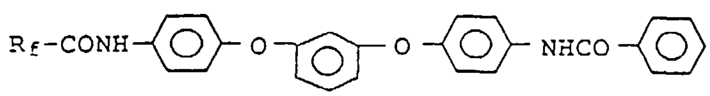

(12) 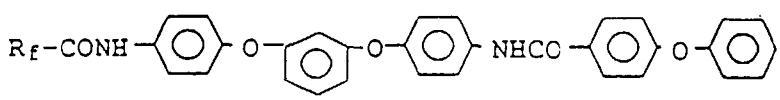

(13) 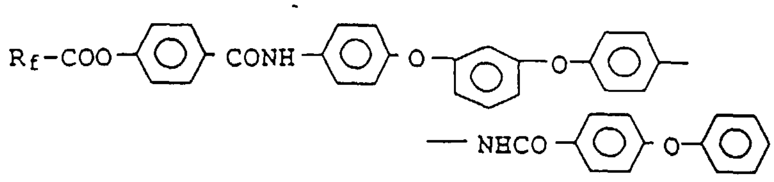

(14) 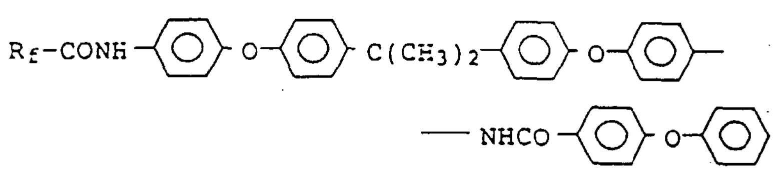

(15) 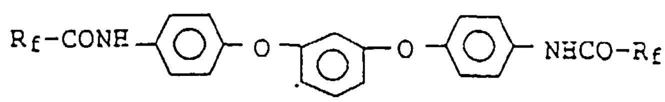

(16) 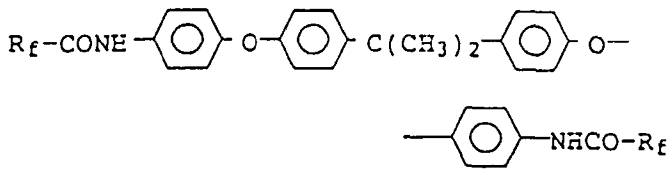

(17) 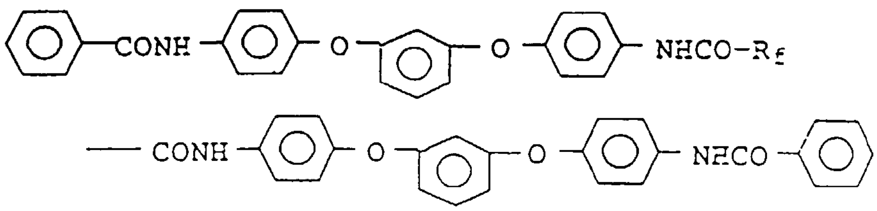

(18) $R_f\text{-}CO(OC_2H_4)_4OH$

(19) $R_f\text{-}CO(OC_2H_4)_{14}OH$

et

(20) $R_f\text{-}CO(OC_2H_4)_4OCH_3$,

où $R_f$ est $F(C_3F_6O)_n\text{-}C_2F_4\text{-}$ dans les composés (1) à (16) et (18) à (20), et $-(C_3F_6O)_{33}\text{-}(CF_2O)_{16}\text{-}CF_2\text{-}$ dans le composé (17) et n est 14 en moyenne.

**6.** Appareils électriques et électroniques selon une ou plusieurs des revendications 1 à 5, caractérisés en ce que les groupes $R_f$ des composés organiques fluorés sont des groupes terminaux.

**7.** Appareils électriques et électroniques selon une ou plusieurs des revendications 1 à 6, caractérisés en ce que la charge inorganique thermoconductrice est un oxyde de métal ayant une thermoconductivité supérieure à 7 W/m.K.

**8.** Appareils électriques et électroniques selon une ou plusieurs des revendications 1 à 7, caractérisés en ce que la charge inorganique thermoconductrice est de l'oxyde de zinc.

**9.** Appareils électriques et électroniques selon une ou plusieurs des revendications 1 à 8, caractérisés en ce que l'huile de base est une huile de poly-α-oléfine.

**10.** Appareils électriques et électroniques selon une ou plusieurs des revendications 1 à 9, caractérisés en ce que le composé organique fluoré est présent dans la composition en une proportion de 0,05 à 14 % en poids, et de préférence de 0,1 à 10 % en poids, sur la base du poids total de la composition.

FIG. 1

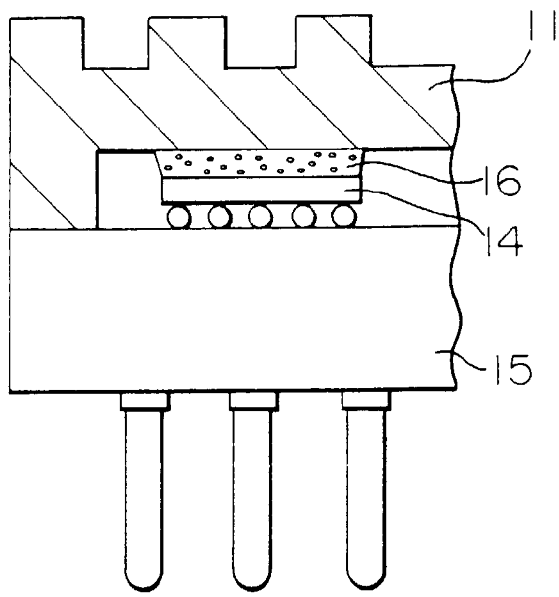


FIG. 2

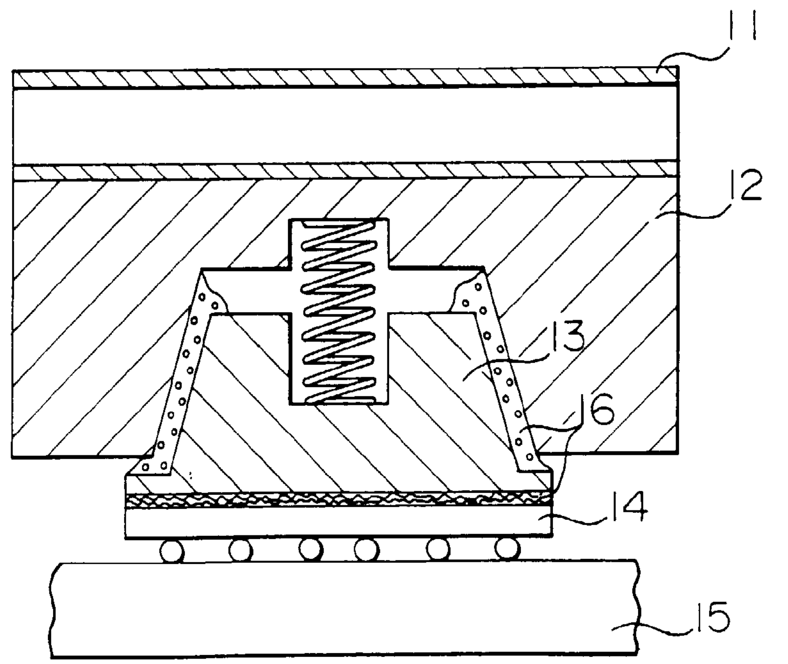

FIG. 3